Europäisches Patentamt

European Patent Office

Office européen des brevets

(11) Veröffentlichungsnummer: **0 095 757**
**A1**

# (12) EUROPÄISCHE PATENTANMELDUNG

(21) Anmeldenummer: 83105284.0

(22) Anmeldetag: 27.05.83

(51) Int. Cl.³: **C 30 B 13/00**, C 01 B 33/02

(30) Priorität: 28.05.82 DE 3220341

(43) Veröffentlichungstag der Anmeldung: 07.12.83
Patentblatt 83/49

(84) Benannte Vertragsstaaten: **DE FR IT**

(71) Anmelder: **SIEMENS AKTIENGESELLSCHAFT, Berlin und München Wittelsbacherplatz 2, D-8000 München 2 (DE)**

(72) Erfinder: **Reuschel, Konrad, Dr., Rosengasse 18, D-8011 Vaterstetten (DE)**

(54) **Verfahren zum Herstellen Polykristalliner, für nachfolgendes Zonenschmelzen geeigneter Siliciumstäbe.**

(57) Zur Verbesserung des Wirkungsgrades von in der Solartechnik einsetzbaren Siliciums wird billiges im Lichtbogenverfahren gewonnenes Silicium, bevor es einem Zonenziehprozeß unterzogen wird, in Stabform gegossen, dabei werden zum Zwecke der wiederholten Benutzbarkeit der Gießform ihre Innenflächen zuerst mit einem Trennmittel (9), das weder mit dem flüssigen Silicium legiert noch mit dem Material der Gießform reagiert, ausgekleidet und danach wird in die so vorbehandelte Form das aus dem Quarzreduktionsofen anfallende flüssige Silicium (5) eingefüllt und gerichtet zum Erstarren gebracht.

0095757

SIEMENS AKTIENGESELLSCHAFT    Unser Zeichen
Berlin und München           VPA    82 P 1 4 2 6 E

**Verfahren zum Herstellen polykristalliner, für nachfolgendes Zonenschmelzen geeigneter Siliciumstäbe**

Zur großtechnischen Umwandlung von Sonnenenergie in
elektrische Energie werden bevorzugt Solarzellen aus
kristallinem Silicium eingesetzt. Dabei ist es wünschenswert, reines aber kostengünstiges Silicium einzusetzen,
aus dem sich Solarzellen mit einem hohen Wirkungsgrad
von beispielsweise mehr als 10 % herstellen lassen.

Zur Herstellung von Solarzellen mit hohen Wirkungsgrad
wird heute allgemein hochreines Silicium als Grundmaterial verwendet, das durch thermische Zersetzung von
mit Wasserstoff verdünntem, gasförmigen, hochreinen
Siliciumverbindungen wie Silicochloroform, Siliciumtetrachlorid oder Silan und Abscheidung auf widerstandsbeheizten Siliciumdünnstäben bei einer Temperatur von ca.
$1100^o$ C gewonnen wird. Die auf diese Weise hergestellten
Siliciumpolystäbe werden durch anschließenden Kristallziehprozeß, z. B. durch Tiegelziehen oder tiegelfreies
Zonenschmelzen, nachgereinigt, in einen Kristall übergeführt, in Scheiben zersägt, und zu Solarzellen weiterverarbeitet. Dieses Verfahren ist technisch relativ aufwendig und daher für großtechnische Siliciumherstellung
zu teuer.

Silicium für technische Anwendungen mit einem zwar
wesentlich niedrigeren Reinheitsgrad von beispielsweise
98,5 % wird heute großtechnisch durch Reduktion von
Quarz mit Kohlenstoff im Lichtbogenofen hergestellt.

Bar 1 Gae / 21.05.1982

Dieser Prozeß arbeitet zwar wirtschaftlich, er ist jedoch nur dann zur Herstellung von Solarsilicium geeignet, wenn es gelingt, den bisher erzielten Reinheitsgrad entscheidend zu erhöhen.

Zu diesem Zweck wurde in der deutschen Patentanmeldung P 32 10 141.4 (VPA 82 P 1201 DE) bereits vorgeschlagen, das nach dem Lichtbogenverfahren gewonnene Silicium in Stabform überzuführen und durch anschließendes, tiegelfreies Zonenschmelzen von den störenden Verunreinigungen zu befreien.

Es ist aber nicht so ohne weiteres möglich, diesen Vorschlag zu verifizieren.

Zunächst haben die Versuche mit Eisen- oder Sandformen, wie sie in der Gießtechnik üblich sind, gezeigt, daß diese bei Metallen üblichen Standardverfahren, wegen der hohen Reaktivität des flüssigen Siliciums und der Ausdehnung des Siliciums während des Erstarrens nicht zu brauchbaren Ergebnissen führen.

Andererseits hat sich aber auch gezeigt, daß es nicht so ohne weiteres möglich ist, gegossenes Silicium durch Zonenschmelzen preiswert zu reinigen. Entweder wird im Gegensatz zum durch thermische Zersetzung gewonnenes Silicium dieses mit vielen Rissen, Lunkern, Bläschen, Einschlüssen und sonstigen Kristallstörungen erhalten oder der Zonenschmelzprozeß muß sehr oft, manchmal mehr als 6 bis 7 mal, wiederholt werden, um ein brauchbares Silicium zu erhalten.

Bekannt ist, daß die technische Qualität des zonengezogenen Solarsiliciums wesentlich verbessert werden kann, wenn das dem Zonenschmelzprozeß zu unterwerfende Silicium nicht nur riß- und lunkerfrei ist; es soll auch frei von störenden Oberflächenschichten sein und bereits höhere Kristallqualität besitzen. Bei qualitativ höherwertigem Silicium gelingt es sogar mit wenigen Zonenzügen versetzungsfreies einkristallines Silicium zu gewinnen, das selbst für manche anspruchsvolleren Halbleiterbauelementen geeignet ist. Die Erfindung geht nun von der Erkenntnis aus, beim Herstellen polykristalliner, für nachfolgendes Zonenschmelzen geeignete Siliciumstäbe durch Gießen flüssigen Siliciums in formgebende Behältnisse mit anschließendem Erstarrenlassen den zonenzuschmelzenden Siliciumstab bereits beim Gießen eine so hohe Kristallqualität zu verleihen, daß an die Kristallperfektionierung beim teuren Zonenschmelzen keine zu hohen Anforderungen mehr gestellt werden müssen.

Bei den bisher vorgeschlagenen Verfahren zum Gießen von Silicium sind trotz aller Vorsicht zusätzliche Verunreinigungen im Silicium entstanden durch Reaktion und/ oder Legierung zwischen dem Silicium und dem Tiegelmaterial, wenn sie unterbunden werden können - so die der Erfindung zugrundeliegende Erkenntnis - dann lassen sich auch die Gießformen wiederholt verwenden.

Bei den bisher vorgeschlagenen Gießverfahren sah man eine Möglichkeit den Tiegeleinfluß gering zu halten darin, daß der Graphittiegel eine hochverdichtete Oberfläche erhielt; damit war das Eindringen des flüssigen Siliciums in die Graphitporen weitestgehend unterbunden. Die Bildung einer Siliciumcarbidschicht konnte aber nie ganz vermieden werden, da es immer Reaktionen an der Oberfläche gibt. Diese Schichten sind zwar nur einige $\mu$m, maximal 20 $\mu$m, stark in Abhängigkeit von der Dichte des oberflächigen Graphits, diese Schichten sind aber dennoch störend.

0095757

Eine andere Möglichkeit sah man darin, auf die Innenseiten des Graphittiegels eine Schutzschicht aus Quarzsand aufzutragen, um somit die Oberfläche zu schützen. Quarz wird bekanntlich vom Silicium nicht benetzt und somit wird das flüssige Silicium gehindert, zum Graphit vorzudringen. Nachteilig ist dabei, daß der Quarzsand aber mit dem flüssigen Silicium zu $SiO_2$ reagiert; dieses wird vom Silicium aufgenommen und eingebrannt.

Obwohl der Gießprozeß so gesteuert werden kann, daß die Verunreinigungen verringert werden, entstehen andererseits durch die Reaktion mit der Tiegelwandung neue Verunreinigungen, die es gemäß vorliegender Erfindung zu vermeiden gilt.

Dementstprechend werden - auch zum Zwecke der wiederholten Benutzbarkeit der Gießform - die Innenflächen zuerst mit einem Trennmittel, das weder mit dem flüssigen Silicium legiert noch mit dem Material der Gießform reagiert, ausgekleidet, anschließend wird in die so vorbehandelte Form das aus dem Quarzreduktionsofen anfallende flüssige Silicium eingefüllt und gerichtet zum Erstarren gebracht.

Dieses Verfahren ist besonders bei den schwierig zu beherrschenden Gießformen aus Graphit, Siliciumcarbid, Siliciumnitrid und Oxidkeramik vorgesehen, wobei als Trennmittelmaterial Blei, Zinn und Bleizinnlegierungen mit unterschiedlichen Blei- bzw. Zinnanteilen zur Anwendung gelangen. Das Material des Trennmittels selbst sollte aber eine Reinheit größer als 99 % besitzen, damit die hierin enthaltenen Verunreinigungen ihrerseits die Siliciumreinheit, z. B. durch Einlegieren oder Eindiffundieren in die Siliciumschmelze, nicht nachteilig beeinflussen.

0095757

Gemäß einer Weiterbildung der Erfindung wird das Material des Trennmittels in Folienform, z. B. in Staniolform, gebracht, wobei die Folienstärke in der Größenordnung von 10 bis 100 /um liegen möge. Mit der Folie läßt sich die Gießform auskleiden und wirkt somit als echte die Reaktion des Siliciums mit dem Tiegelmaterial vermeidende Barriere.

Leichter zu handhaben ist eine alternative Weiterbildung der Erfindung. Insbesondere dann, wenn die Gießform aus mehreren Teilformen besteht. Durch diese Formgebung wird der radialen Ausdehnung des Siliciums Rechnung getragen. Hiernach wird das Material des Trennmittels in Pulverform gebracht und mit einem organischen Lösungsmittel aufgeschlemmt. Geeignete Lösungsmittel sind niedrigsiedende Alkohole, wie Methanalkohol, Äthylalkohol oder auch Isopropanol.

Hiermit läßt sich eine mehr oder weniger dünnflüssige aber streichfähige Paste herstellen, die in einer Stärke von maximal 100 /um auf die Innenflächen der Gießform, z. B. mittels eines Pinsels, auftragbar ist. Selbstverständlich kann das Material auch aufgesprüht oder anderweitig aufgebracht werden.

Zweckmäßigerweise wird das verwendete Lösungsmittel vor dem Gießvorgang ggf. durch Vorheizen zum Verdunsten gebracht.

Da bei der thermischen Beanspruchung des Trennmittels mit einem wenn auch noch so geringfügigen Einfluß auf die Siliciumschmelze gerechnet werden muß, wurden die Materialien hierfür nicht nur hinsichtlich ihrer Inaktivität gegenüber Silicium und dem Tiegelmaterial ermittelt, mit entscheidend war auch die Überlegung, daß bei solch einem Material die maximale Löslichkeit im Silicium in Abhängigkeit vom Verteilungskoeffizienten einen optimalen Wert haben muß (beim Blei z. B. beträgt sie $7 \times 10^{-5}$).

Oberflächliches Blei z. B. braucht nicht während des nachfolgenden Zonenschmelzen mit entfernt werden, es kann auch in einem eigenen und billigen Verfahrensschritt eliminiert werden.

Abgesehen davon, daß eine dünne Oberflächenschicht des erstarrten Siliciumstabes durch Schleifen oder Sandstrahlen abtragbar ist, läßt sich oberflächliches Blei durch Waschen in Salpetersäure oder durch Anätzen mittels eines alkalischen Ätzmittels entfernen.

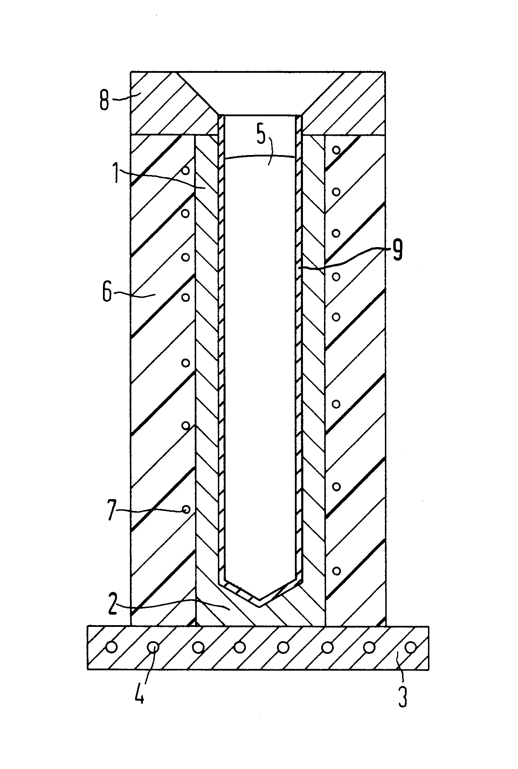

Der Einsatz der Erfindung wird anhand der Figur noch verdeutlicht. Kernstück der Gießform, bei der die Erfindung Anwendung finden soll, ist der aus Graphit bestehende vertikal angeordnete Hohlzylinder 1. Der den Hohlzylinder nach unten abschließende Boden 2 ist thermisch mit der Edelstahlplatte 3 verbunden, diese Grundplatte ist mit Bohrungen bzw. Führungen 4 für das erforderliche Kühlwasser ausgestattet.

Der Hohlzylinder 1 ist auf seiner Innenseite mit der Schicht 9 ausgekleidet. Sie muß bei einer Stärke von etwa 10 bis 100 /um als echtes Trennmittel jegliche Reaktion zwischen dem anfangs schmelzflüssigen Silicium und dem Tiegelmaterial verhindern.

Das in einem Lichtbogenofen erzeugte schmelzflüssige Silicium wird bei einer Temperatur zwischen $1430^{\circ}$ und $1470^{\circ}$ C, vorzugsweise bei $1450^{\circ}$ C, in einem Zug aus einem in der Zeichnung nicht dargestellten Vorratsgefäß

0095757

in die Kokille 1, 2 gegossen, die eine Länge von 100 cm, einen Innendurchmesser von 60 mm und eine Wandstärke von 20 mm hat, sie wurde vor dem Gießvorgang auf etwa 1200° C vorgewärmt.

Nach oben ist die Gußvorrichtung durch eine trichterförmig ausgebildete, ebenfalls aus Graphit bestehende Einfüllhilfe 8 abgeschlossen.

Wesentlich ist, daß die Erstarrung des Siliciums 5 gerichtet vom Boden 2 zum Kopf hin, also zur freien Stirnfläche des Hohlzylinders 1 hin, erfolgt. Erreichen läßt sich dies durch die kühlbare Unterlage 3, auf die die Kokille 1, 2 gestellt wird, und durch eine Beheizung des Hohlzylinders.

Als Heizeinrichtung dient ein die Kokille konzentrisch umschließendes Keramikrohr 6, in das Heizdrähte 7 für eine Widerstandsheizung dieses Rohres 6 eingelassen sind. Die Heizleistung ist um eine Abkühlung der Schmelze zu ermöglichen in ihrer Intensität steuerbar. Die Heizdrähte haben aber darüberhinaus noch unterschiedliche Abstände, so daß der Kokillenkopf mit etwa 1000° C am heißesten ist und daher am Schluß erstarrt.

Nach dem Erkalten des Siliciums wird vor einem nachfolgenden Zonenschmelzprozeß an der Siliciumoberfläche anhaftendes Material des Trennmittels in einem eigenen an sich bekannten Verfahrensschritt wieder entfernt.

Patentansprüche

1. Verfahren zum Herstellen polykristalliner, für nachfolgendes Zonenschmelzen geeigneter Siliciumstäbe durch Gießen flüssigen Siliciums in einen Ingot, d a - d u r c h  g e k e n n z e i c h n e t, daß zum Zwecke der wiederholten Benutzbarkeit der Gießform ihre Innenflächen zuerst mit einem Trennmittel, das weder mit dem flüssigen Silicium legiert noch mit dem Material der Gießform reagiert, ausgekleidet und danach in die so vorbehandelte Form das aus dem Quarzreduktionsofen anfallende flüssige Silicium eingefüllt und gerichtet zum Erstarren gebracht wird.

2. Verfahren nach Anspruch 1, d a d u r c h  g e - k e n n z e i c h n e t, daß die Gießform aus Graphit besteht.

3. Verfahren nach Anspruch 1, d a d u r c h  g e - k e n n z e i c h n e t, daß die Gießform aus Siliciumcarbid besteht.

4. Verfahren nach Anspruch 1, d a d u r c h  g e - k e n n z e i c h n e t, daß die Gießform aus Siliciumnitrid besteht.

5. Verfahren nach Anspruch 1, d a d u r c h  g e - k e n n z e i c h n e t, daß die Gießform aus Oxidkeramik besteht.

6. Verfahren nach wenigstens einem der Ansprüche 1 bis 5, d a d u r c h  g e k e n n z e i c h n e t, daß als Trennmittelmaterial Blei Verwendung findet.

7. Verfahren nach wenigstens einem der Ansprüche 1 bis 5, d a d u r c h   g e k e n n z e i c h n e t, daß als Trennmittelmaterial Zinn Verwendung findet.

8. Verfahren nach wenigstens einem der Ansprüche 1 bis 5, d a d u r c h   g e k e n n z e i c h n e t, daß als Trennmittelmaterial eine Blei-Zinn-Legierung Verwendung findet.

9. Verfahren nach wenigstens einem der Ansprüche 1 bis 8, d a d u r c h   g e k e n n z e i c h n e t, daß das Trennmittelmaterial eine Reinheit größer als 99 % besitzt.

10. Verfahren nach wenigstens einem der Ansprüche 1 bis 9, d a d u r c h   g e k e n n z e i c h n e t, daß das Material des Trennmittels in Folienform gebracht wird, um damit die Gießform auszukleiden.

11. Verfahren nach Anspruch 10, d a d u r c h   g e - k e n n z e i c h n e t, daß die Folie eine Stärke in der Größenordnung von 10 bis 100 $\mu$m besitzt.

12. Verfahren nach wenigstens einem der Ansprüche 1 bis 9, d a d u r c h   g e k e n n z e i c h n e t, daß das Material des Trennmittels in Pulverform gebracht und mit einem organischen Lösungsmittel ausgeschlemmt wird.

13. Verfahren nach Anspruch 12, d a d u r c h   g e - k e n n z e i c h n e t, daß als organisches Lösungs- mittel niedrigsiedende Alkohole wie Methylalkohol, Äthylalkohol, oder Isoprophanol Verwendung finden.

14. Verfahren nach wenigstens einem der Ansprüche 1 bis 13, d a d u r c h   g e k e n n z e i c h n e t, daß eine streichfähige Paste gebildet wird, um sie auf die Innenflächen der Gießform aufzutragen.

0095757

15. Verfahren nach wenigstens einem der Ansprüche 1 bis 14, dadurch gekennzeichnet, daß die Paste in einer Stärke von maximal 100 /um aufgetragen wird.

16. Verfahren nach wenigstens einem der Ansprüche 1 bis 15, dadurch gekennzeichnet, daß vor dem Gießvorgang das Lösungsmittel ggf. durch Vorheizen zum Verdunsten gebracht wird.

17. Verfahren nach wenigstens einem der Ansprüche 1 bis 16, dadurch gekennzeichnet, daß eine auf der Oberfläche des Siliciumstabes haftende Schicht des Trennmaterials vor dem Zonenschmelzen durch Sandstrahlen entfernt wird.

18. Verfahren nach wenigstens einem der Ansprüche 1 bis 17, dadurch gekennzeichnet, daß eine auf der Oberfläche des Siliciumstabes haftende Schicht des Trennmaterials vor dem Zonenschmelzen durch Waschen in Säure, z. B. Salpetersäure, entfernt wird.

19. Verfahren nach wenigstens einem der Ansprüche 1 bis 17, dadurch gekennzeichnet, daß eine auf der Oberfläche des Siliciumstabes haftende Schicht des Trennmaterials vor dem Zonenschmelzen durch Ätzen mittels eines alkalischen Ätzmittels entfernt wird.

20. Verfahren nach wenigstens einem der Ansprüche 1 bis 17, dadurch gekennzeichnet, daß eine auf der Oberfläche des Siliciumstabes haftende Schicht des Trennmaterials vor dem Zonenschmelzen durch Schleifen entfernt wird.

Europäisches
Patentamt

# EUROPÄISCHER RECHERCHENBERICHT

0095757
Nummer der Anmeldung

EP 83 10 5284

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | EP-A-0 010 307 (CONSORTIUM FÜR ELEKTROCHEMISCHE INDUSTRIE)<br><br>--- | | C 30 B 13/00<br>C 01 B 33/02 |
| A | FIFTEENTH IEEE PHOTOVOLTAIC SPECIALISTS CONFERENCE - 1981, 12.-15. Mai 1981, Seiten 576-580, Kissimmee, Florida, USA T. SAITO et al.: "A new directional solidification technique for polycrystalline solar grade silicon"<br><br>--- | | |
| A | PATENTS ABSTRACTS OF JAPAN, Band 5, Nr. 179 (E-82)[851], 17. November 1981 & JP - A - 56 105 623 (KOGYO GIJUTSUIN) 22.08.1981<br><br>----- | | |

| RECHERCHIERTE SACHGEBIETE (Int. Cl. ³) |
|---|
| C 30 B 13/00<br>C 01 B 33/02<br>C 30 B 11/00<br>C 30 B 13/14<br>C 30 B 35/00<br>C 30 B 29/06 |

Der vorliegende Recherchenbericht wurde für alle Patentansprüche erstellt.

| Recherchenort<br>DEN HAAG | Abschlußdatum der Recherche<br>06-09-1983 | Prüfer<br>BRACKE P.P.J.L. |
|---|---|---|